# EUROPEAN PATENT APPLICATION

(11) **EP 0 824 271 A1**
(43) Date of publication of application: **18.02.1998**
(21) Application number: 97113402.8
(22) Date of filing: 04.08.1997
(51) Int. Cl.: H01L 21/762

(54) **Dielectric isolation substrate and method for manufacturing the same**

(30) Priority: 06.08.1996 JP 206940/96
(71) Applicant: NEC CORPORATION, Tokyo (JP)
(72) Inventor: Kobayashi, Kenya, Minato-ku, Tokyo (JP)
(74) Representative: Betten & Resch

(57) **Abstract**

A dielectric isolation substrate includes a polysilicon layer, an insulating film, and a first single-crystal silicon layer. The polysilicon layer is formed on a single-crystal silicon substrate. The insulating film is formed on a portion of the polysilicon layer excluding a vertical element formation region. The first single-crystal silicon layer is formed on the polysilicon layer and the insulating layer. The first single-crystal silicon layer is separated into a plurality of island regions which include the vertical element formation region and which are isolated by the insulating film. A single-crystal silicon layer including at least the first single-crystal silicon layer, the polysilicon layer, and the single-crystal silicon substrate constitute a three-layer structure in the vertical element formation region. A method of manufacturing the dielectric isolation substrate is also disclosed.

## Description

### Background of the Invention

The present invention relates to a dielectric isolation substrate and a method of manufacturing the same and, more particularly, to a dielectric isolation substrate having a vertical element formation region and a method of manufacturing the same.

In a semiconductor IC (integrated circuit), in order to operate elements having various characteristics at high reliability without being influenced by each other, a dielectric isolation substrate in which the respective element formation regions are isolated from each other by a dielectric is used. In recent years, power ICs in which low-breakdown voltage control circuits and high-breakdown voltage power elements that can use a large current are monolithically integrated have been used in a variety of applications. To use a large current, a vertical power MOSFET (Metal Oxide Semiconductor Field Effect Transistor), a vertical IGBT (Insulated-Gate Bipolar Transistor), and the like in which the current can flow in the vertical direction are effective. How to monolithically integrate such a vertical element and a control circuit is a technical issue.

A conventional method of manufacturing a dielectric insulation substrate in which power ICs of this type can be formed will be described with reference to the manufacturing steps in Figs. 3A to 3F. As shown in Fig. 3A, an insulating film 2 made of an oxide film is formed on one surface of a single-crystal silicon substrate 1 having the (100) direction. The insulating film 2 is patterned, and element isolation V-grooves (to be referred to as isolation grooves hereinafter) 3 are formed in the single-crystal silicon substrate 1 by alkali etching using the insulating film 2 as the mask.

The insulating film 2 is removed, and thereafter an insulating film 4 made by thermal oxidation is formed again on one surface of the single-crystal silicon substrate 1 including the inner surfaces of the isolation grooves 3, as shown in Fig. 3B. Subsequently, an epitaxial polysilicon layer 13 is formed on the insulating film 4. When epitaxial growth is performed on the insulating film 4, a polysilicon layer is formed.

The surface of the epitaxial polysilicon layer 13 is planarized by polishing, and thereafter an insulating film 14 made of an oxide film is formed on the epitaxial polysilicon layer 13, as shown in Fig. 3C. Subsequently, the insulating film 14, the epitaxial polysilicon layer 13, and the insulating film 4 at a portion corresponding to the vertical element formation region are removed by etching, thereby exposing the surface of the single-crystal silicon substrate 1.

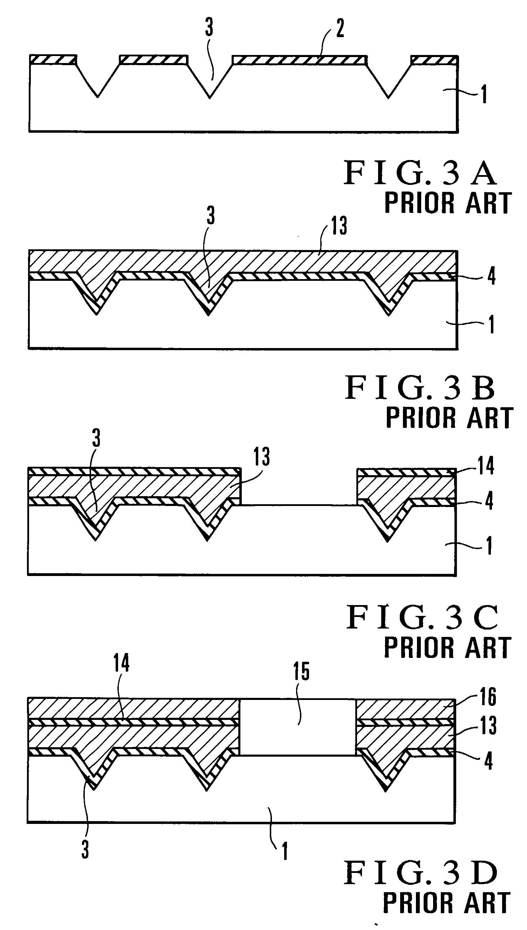

Epitaxial growth is performed again, as shown in Fig. 3D, to form an epitaxial single-crystal silicon layer 15 on the exposed portion of the single-crystal silicon substrate 1, and an epitaxial polysilicon layer 16 is formed on the insulating film 14.

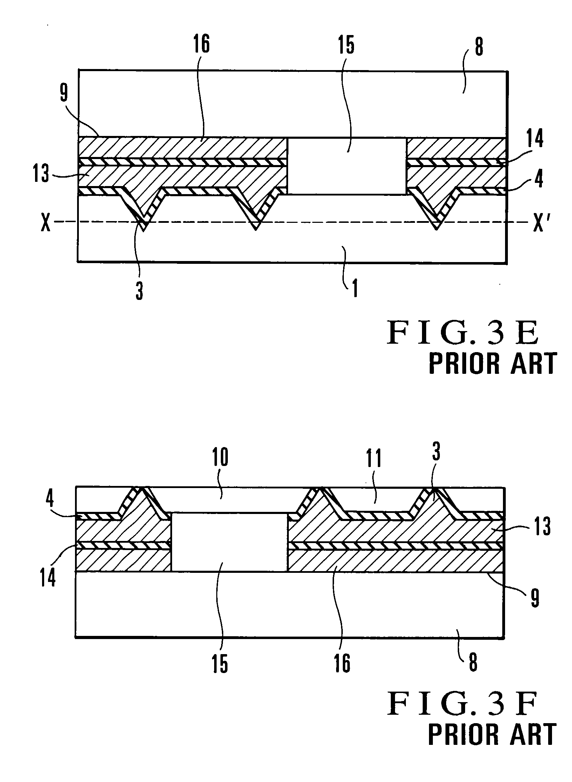

The surfaces of the epitaxial single-crystal silicon layer 15 and epitaxial polysilicon layer 16 are planarized by polishing, and a single-crystal silicon substrate 8 is adhered to the polished surfaces, as shown in Fig. 3E. Reference numeral 9 denotes an adhesion surface where the two substrates 1 and 8 are adhered.

The single-crystal silicon substrate 1 is polished from the other surface until its X - X' surface where the distal ends (bottom portions) of the isolation grooves 3 appear, to form a dielectric isolation substrate having a vertical element formation region 10 and single-crystal silicon islands 11, as shown in Fig. 3F.

In the conventional technique described above, however, since high-temperature, long-time epitaxial growth must be performed twice, a large number of crystal defects are formed. If a single-crystal silicon layer and a polysilicon layer mixedly exist on the adhesion surface 9 of the substrate 1, it is very difficult to polish the adhesion surface 9 very flat due to the difference in crystallinity. Therefore, when the substrate 8 is adhered to the surface of the substrate 1 which is not very flat, a void may be formed.

When a void is formed, it may expand in heating after adhesion of the two substrates 1 and 2 or in heating during element formation to cause burst, or to form a crack or cutout during dicing, which result in major obstacles in the manufacturing process.

### Summary of the Invention

It is an object of the present invention to provide a dielectric isolation substrate in which generation of crystal defects is suppressed by reducing the number of times of high-temperature, long-time epitaxial growth, and a method of manufacturing the same.

It is another object of the present invention to provide a dielectric isolation substrate in which a void is prevented by uniforming the adhesion surface of the two substrates, thereby improving the manufacturing yield, and a method of manufacturing the same.

In order to achieve the above objects, according to the present invention, there is provided a dielectric isolation substrate comprising a first polysilicon layer formed on a single-crystal silicon substrate, an insulating film formed on a portion of the first polysilicon layer excluding a vertical element formation region, and a first single-crystal silicon layer formed on the first polysilicon layer and the insulating layer, the first single-crystal silicon layer being separated into a plurality of island regions which include the vertical element formation region and which are isolated by the insulating film, wherein a single-crystal silicon layer including at least the first single-crystal silicon layer, the first polysilicon layer, and the single-crystal silicon substrate constitute a three-layer structure in the vertical element formation region.

### Brief Description of the Drawings

Figs. 1A to 1F are sectional views showing the steps in manufacturing a dielectric isolation substrate according to the first embodiment of the present invention;
Figs. 2A to 2E are sectional views showing the steps in manufacturing a dielectric isolation substrate according to the second embodiment of the present invention; and
Figs. 3A to 3F are sectional views showing the steps in manufacturing a conventional dielectric isolation substrate.

### Description of the Preferred Embodiments

The present invention will be described in detail with reference to the accompanying drawings.

### (First Embodiment)

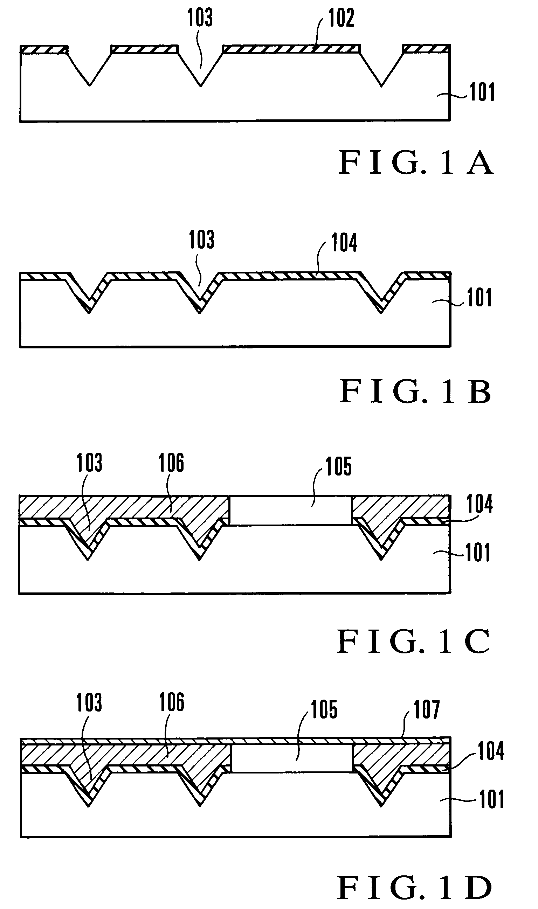

Figs. 1A to 1F show the steps in manufacturing a dielectric isolation substrate according to the first embodiment of the present invention. According to the first embodiment, as a single-crystal silicon substrate 101, one having the (100) direction and a comparatively high resistance is used. The resistivity of the single-crystal silicon substrate 101 is limited within a certain range by the characteristics required by the element to be formed in this single-crystal silicon substrate 101. If the vertical element is a power element, the resistivity is determined by its breakdown voltage characteristics. For example, when an n-channel vertical IGBT having a breakdown voltage of several 100 V to 1,000 V is to be formed, an n-type single-crystal silicon substrate having a resistivity of about several 10 Ω·cm to 100 Ω·cm is used.

An insulating film 102 made of a silicon dioxide film is formed on one surface of the single-crystal silicon substrate 101 by thermal oxidation, as shown in Fig. 1A. The insulating film 102 is selectively removed by photolithography and etching. Alkali etching is performed by using the residual portion of the insulating film 102 as the mask, thereby forming isolation grooves 103 in the single-crystal silicon substrate 101.

The depth of the isolation grooves 103 concerns determination of the breakdown voltage of the power element. For example, to obtain the breakdown voltage described above, a depth of about several 10 µm to 100 µm is required. The deeper the isolation grooves 103 are, the thicker the insulating film 102 must be. In order to obtain the breakdown voltage described above, the insulating film 102 preferably has a thickness of about 2 to 3 µm.

The insulating film 102 is removed, and thereafter an element isolation insulating film 104 is formed on one surface of the single-crystal silicon substrate 101 and the surfaces of the isolation grooves 103 by thermal oxidation, as shown in Fig. 1B. The thickness of the insulating film 104 is determined by the required element isolation breakdown voltage. The insulating film 104 requires a thickness of about 2 to 3 µm or more.

A portion of the insulating film 104 serving as the prospective vertical element formation region is removed by etching. At least one vertical element formation region is formed on the substrate 101. It is a matter of course that the vertical element formation region is formed between the two adjacent isolation grooves 103.

Epitaxial growth is performed at a temperature of, e.g., about 1,100°C, by using trichlorosilane, silicon tetrachloride, or the like as the source gas. Epitaxial growth is performed while doping a required amount of impurity so that the resistance of the vertical element decreases, to fill the isolation grooves 103 and to further provide a thickness of several 10 µm. At this time, as shown in Fig. 1C, an epitaxial single-crystal silicon layer 105 is formed on a surface where the single-crystal silicon substrate 101 is exposed, and an epitaxial polysilicon layer 106 is formed on the insulating film 104.

Since uneven portions are formed on the surfaces of the epitaxial single-crystal silicon layer 105 and epitaxial polysilicon layer 106 in accordance with the shapes of the isolation grooves 103, such unevenness is ground and polished by using chemical-mechanical polishing (CMP), thereby planarizing the surfaces of the epitaxial polysilicon layer 106 and single-crystal silicon layer 105. Small steps on the polished surfaces are not eliminated due to the difference in crystallinity between single-crystal silicon and polysilicon.

As shown in Fig. 1D, a thin polysilicon layer 107 having a thickness of about 1 µm is formed on the epitaxial single-crystal silicon layer 105 and the epitaxial polysilicon layer 106. In order to eliminate the small steps described above, the grain boundary of the polysilicon layer 107 must be decreased. For this purpose, the polysilicon layer 107 is formed at a comparatively low temperature, e.g., 400°C to 1,100°C, and preferably about 650°C, in accordance with chemical vapor deposition (CVD). The source gas is silane, dichlorosilane, or the like.

The surface of the polysilicon layer 107 is polished by using chemical-mechanical polishing to form a very flat surface having a surface step of 0.01 µm or less.

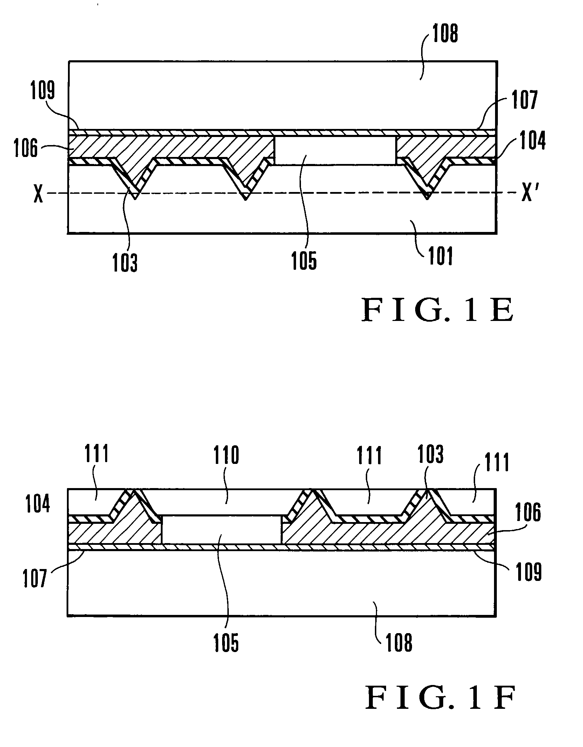

As shown in Fig. 1E, a single-crystal silicon substrate 108 having a comparatively low resistance is adhered to the very flat surface of the polysilicon layer 107 at room temperature in an atmosphere. The resultant structure is heated at a temperature of 1,100°C to 1,200°C for about 1 to 2 hours, thereby obtaining one adhesion substrate in which the polysilicon layer 107 and the single-crystal silicon substrate 108 are firmly bonded to each other.

The single-crystal silicon substrate 101 is ground and polished from the other surface until its X - X' surface where the distal ends (bottom portions) of the isolation grooves 103 appear, thereby forming a substrate having at least one vertical element formation region 110 and a plurality of single-crystal silicon islands 111 that are isolated from each other by a dielectric, as shown in Fig. 1F.

In the vertical element formation region 110, the polysilicon layer 107 is sandwiched between the epitaxial single-crystal silicon layer 105 and the single-crystal silicon substrate 108. When the resultant structure is heated after adhesion or during element formation, the impurity in the epitaxial single-crystal silicon layer 105 and single-crystal silicon substrate 108 is diffused into the polysilicon layer 107 to sufficiently decrease the resistivity of the polysilicon layer 107. Accordingly, the polysilicon layer 107 in the vertical element formation region 110 does not adversely affect the current characteristic of the element.

The polysilicon layer 107 in the first embodiment is an effective means for obtaining a very flat adhesion surface 109 when precise planarization of the surface is difficult to perform due to the difference in crystallinity, like between the epitaxial single-crystal silicon layer 105 and the epitaxial polysilicon layer 106.

When this method is applied to the conventional technique, a polysilicon layer is formed on the epitaxial single-crystal silicon layer 15 and the epitaxial polysilicon layer 16 shown in Fig. 3E, the surface of the epitaxial polysilicon layer 16 is planarized very much, and the single-crystal silicon substrate 8 is adhered, thereby preventing a void.

### (Second Embodiment)

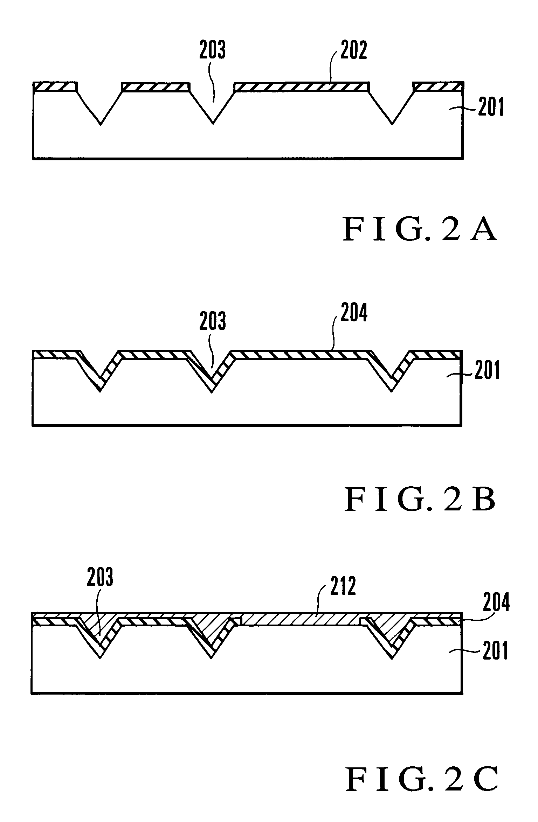

Figs. 2A to 2E show the steps in manufacturing a dielectric isolation substrate according to the second embodiment of the present invention. An insulating film 202 made of a silicon oxide film is formed on one surface of a single-crystal silicon substrate 201 by thermal oxidation, as shown in Fig. 2A. The insulating film 202 is selectively removed by photolithography and etching. Alkali etching is performed by using the residual portion of the insulating film 202 as the mask, thereby forming isolation grooves 203 in the single-crystal silicon substrate 201.

The insulating film 202 is removed, and thereafter an element isolation insulating film 204 is formed on one surface of the single-crystal silicon substrate 201 and the surfaces of the isolation grooves 203 by thermal oxidation, as shown in Fig. 2B. These manufacturing steps are similar to those shown in Figs. 1A and 1B.

A portion of the insulating film 204 serving as the prospective vertical element formation region is removed by etching to expose the single-crystal silicon substrate 201. A polysilicon layer 212 is formed on the surface where the exposed surface of the single-crystal silicon substrate 201 and the insulating film 204 mixedly exist, as shown in Fig. 2C. The polysilicon layer 212 is formed at a low temperature of 400°C to 1,100°C by epitaxial growth or CVD so that silicon being grown on the single-crystal silicon substrate 201 will not become single-crystal silicon. The source gas is silane, dichlorosilane, or the like.

The surface of the polysilicon layer 212 having unevenness is planarized to a high degree in accordance with CMP. The polysilicon layer 212 is ground and polished until immediately before the insulating film 204 is exposed, such that the thickness of the polysilicon layer 212 on the exposed surface of the single-crystal silicon substrate 201 becomes several µm.

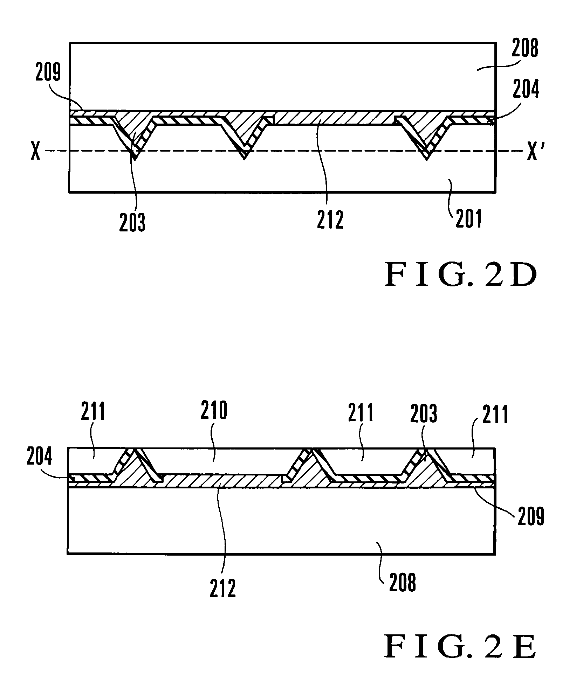

The manufacturing steps after this are similar to those shown in Figs. 1E and 1F. More specifically, as shown in Fig. 2D, a single-crystal silicon substrate 208 is adhered to the very flat surface of the polysilicon layer 212. The other surface of the single-crystal silicon substrate 201 is ground and polished until the X - X' surface. As a result, a substrate in which at least one vertical element formation region 210 and a plurality of single-crystal silicon islands 211 are isolated from each other by dielectrics, as shown in Fig. 2E, is manufactured.

In the same manner as in the first embodiment, the polysilicon layer 212 in the vertical element formation region 210 does not inversely affect the current characteristic of the element. This is because the impurity in the two single-crystal silicon layers sandwiching the polysilicon layer 212 is diffused into the polysilicon layer 212 by heating after adhesion and by heating during element formation to sufficiently decrease the resistivity of the polysilicon layer 212.

As has been described above, according to the present invention, high-temperature, long-time epitaxial growth which has conventionally been performed twice can be reduced to one high-temperature, long-time growth and one low-temperature CVD, or to one low-temperature growth only, so that generation of crystal defects can be suppressed. As a result, the yield of the ICs which has been low due to degradation of the element characteristics can be improved.

Since the adhesion surface is a uniform polysilicon layer, it can be planarized very much to prevent void generation. As a result, a highly reliable substrate can be obtained.

## Claims

1. A dielectric isolation substrate characterized by comprising:
a first polysilicon layer (107, 212) formed on a single-crystal silicon substrate (108, 208);
an insulating film (104, 204) formed on a portion of said first polysilicon layer excluding a vertical element formation region (110, 210); and
a first single-crystal silicon layer (101, 201) formed on said first polysilicon layer and said insulating layer, said first single-crystal silicon layer being separated into a plurality of island regions (111, 211) which include said vertical element formation region and which are isolated by said insulating film,
wherein a single-crystal silicon layer including at least said first single-crystal silicon layer, said first polysilicon layer, and said single-crystal silicon substrate constitute a three-layer structure in said vertical element formation region.

2. A substrate according to claim 1, further comprising
a second single-crystal silicon layer (105) formed in said vertical element formation region between said first polysilicon layer and said first single-crystal silicon layer, and
a second polysilicon layer (106) formed in a region excluding said vertical element formation region between said first polysilicon layer and said insulating film, and
wherein said first and second single-crystal silicon layers, said first polysilicon layer, and said single-crystal silicon substrate constitute said three-layer structure.

3. A substrate according to claim 1, wherein
said first polysilicon layer is formed in said vertical element formation region to be in direct contact with said single-crystal silicon substrate and said first single-crystal silicon layer, and
said first single-crystal silicon layer, said first polysilicon layer, and said single-crystal silicon substrate constitute said three-layer structure.

4. A substrate according to claim 1, wherein said insulating film forms an element isolation layer at a boundary of said island regions.

5. A method of manufacturing a dielectric isolation substrate, characterized by comprising the steps of:
forming element isolation grooves (103, 203) in one surface of a first single-crystal silicon substrate (101, 201), said grooves being formed at boundaries of a plurality of island regions (111, 211) including at least one vertical element formation region (110, 210);
forming an insulating film (104, 204) on one surface of said first single-crystal silicon substrate and surfaces of said grooves;
removing said insulating film at a portion corresponding to said vertical element formation region between said grooves, thereby exposing said first single-crystal silicon substrate;
forming a first polysilicon layer (107, 212) on an exposed portion of said first single-crystal silicon substrate and said insulating film;
planarizing a surface of said first polysilicon layer;
adhering one surface of a second single-crystal silicon substrate (108, 208) on a planarized surface of said first polysilicon layer; and
polishing the other surface of said first single-crystal silicon substrate until distal ends of said grooves appear.

6. A method according to claim 5, wherein
the step of forming said first polysilicon layer comprises the steps of
forming a single-crystal silicon layer (105) and a second polysilicon layer (106) on said exposed portion of said first single-crystal silicon substrate and said insulating film including inner surfaces of said grooves, respectively,
polishing surfaces of said single-crystal silicon substrate and of said second polysilicon layer, and
forming said first polysilicon layer on said single-crystal silicon substrate and said second polysilicon layer that are polished.

7. A method according to claim 5, wherein
the step of forming said first polysilicon layer comprises
the step of directly forming said first polysilicon layer on said exposed portion of said first single-crystal silicon substrate and said insulating film including inner surfaces of said grooves.
